# EUROPEAN PATENT SPECIFICATION

(11) **EP 1 211 735 B1**
(45) Date of publication and mention of the grant of the patent: **26.04.2006**
(21) Application number: 00126394.6
(22) Date of filing: 04.12.2000
(51) Int. Cl.: H01L 33/00

(54) **Light emitting diode with improved heat dissipation**
Licht-emittierende Diode mit verbesserter Wärmezerstreuung
Diode électroluminescente avec dissipation de chaleur améliorée

(43) Date of publication of application: 05.06.2002
(73) Proprietor: Yu, Mu-Chin, Tu Cheng, Taipei Hsien (TW)
(72) Inventor: Yu, Mu-Chin, Tu Cheng, Taipei Hsien (TW)
(74) Representative: Helms, Joachim

(56) References cited:
- EP-A- 0 687 042
- WO-A-96/18210
- WO-A-99/07023
- WO-A-99/60626
- DE-A- 2 315 709
- US-A- 4 478 588
- PATENT ABSTRACTS OF JAPAN vol. 018, no. 556 (E-1620), 24 October 1994 (1994-10-24) -& JP 06 204604 A (SANYO ELECTRIC CO), 22 July 1994 (1994-07-22)

## Description

### 1. Field of The Invention:

The present invention relates to an improved light emitting diode, and particularly to a light emitting diode, which provides a base with a bottom part thereof free from sealing and exposing outside for a better heat dissipation.

### 2. Description of Related Art:

A light emitting diode has been used as an effective light source for years. The light emitting diode provides advantages such as a longer life span, a higher lightness and lower power consumption such that it is widely applied in a signaling light, a brake light on a car, a Christmas decorative light, and etc.. In addition, the light emitting diode can provides an effect of instant flash by way of circuit design as desired. Therefore, the light emitting diode is popularly used and there is a tendency for the light emitting diode to replace the conventional tungsten lamp.

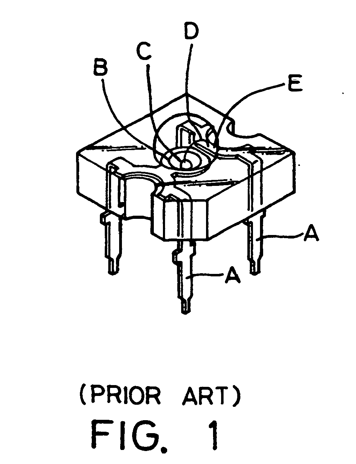

As shown in Fig. 1, a typical light emitting diode provides at least two connecting pins "A" as a positive pole and a negative pole respectively. A base "B" is disposed above one of the poles at a lateral side thereof to receive a crystal chip "C" and a brazed wire connects a nodal plate "E" extended from the other pole to constitute a circuit. The above said pins "A", base "B", nodal plate "E" are made of conductive sheet metal, and, in practice, are produced by way of integrally punch pressing a strip of conductive sheet metal.

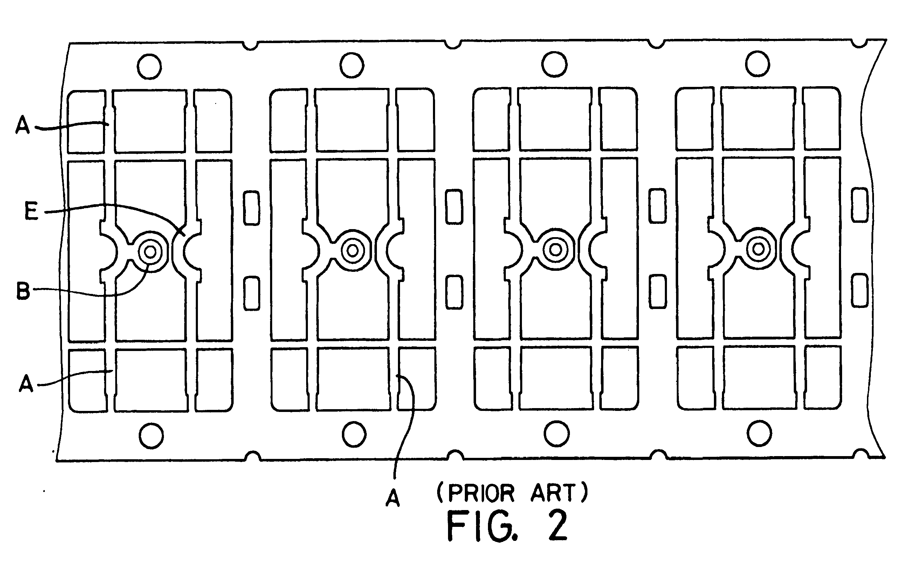

As shown in Fig. 2, a blank sheet used for a prior art light emitting diode is illustrated. It can be seen that the blank sheet has been punch pressed to form a plurality of blank sections. Each blank section has connecting pins "A", the base "B", and the nodal plate "E", and the base "B" has a shape of concave inward cone. The rest unnecessary parts are cut out as removals.

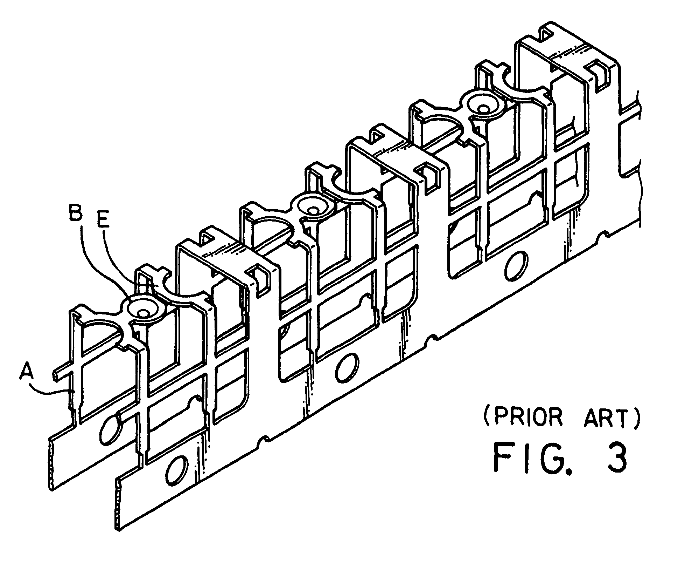

As shown in Fig. 3, a bent blank is illustrated. Each connecting pin "A" in the respective blank section is bent into an angle of 90 degrees with respect to the base "B" and the nodal plate "E", and then the nodal plate "E" and the chip "C" can be connected with each other via a brazed wire "D".

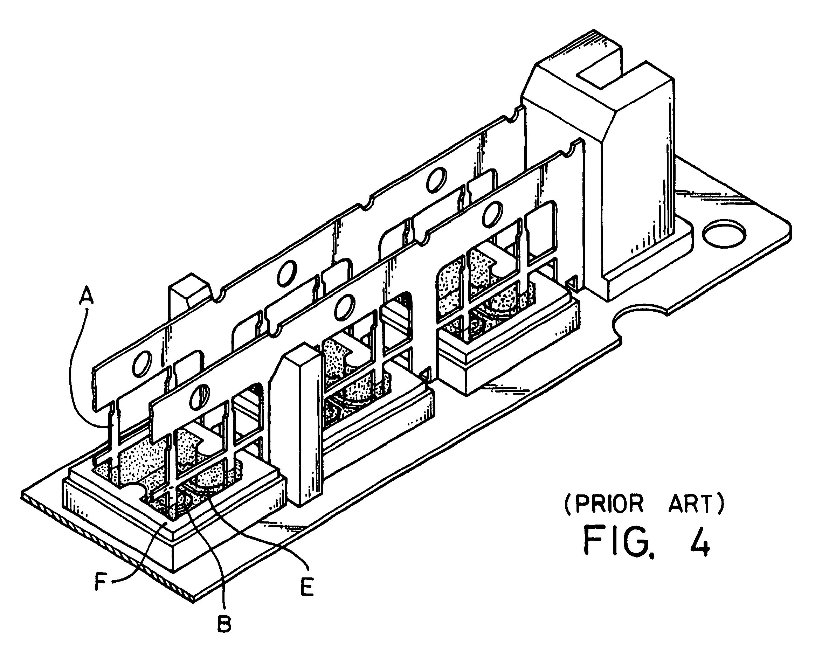

In order to assure a protection for all parts related to the circuit, each blank section is insulated by way of sealing compound. As shown in Fig. 4, a hold fixture is provided with recessions to fit with pattern frames "F". Each blank section is received in each pattern frame "F" and fits with the pattern frame such that the base "B" and the nodal plate "E" are disposed in the pattern frame. Then, the transparent sealing compound such as epoxy resin is poured into each pattern frame "F" to be flush with the upper surface of the pattern frame "F". When the poured sealing compound is solidified, the sealed blank sections are taken out and apart from the pattern frames "F" respectively. Finally, the sealed blank sections are separate into individual light emitting diodes and each of the light emitting diodes is like the one shown in Fig. 1. As shown in Fig. 1, the base "B" is completely covered by the sealing compound and insulated from the outside and the parts above the base "B" are also in a state of being sealed to insulate from the outside.

Once the light emitting diode is started in a state of on instantaneously, an instantaneous current consumption is great so as to generate a higher temperature in the light emitting diode. When the light emitting diode is kept "on" for a long period of time, the heat generated from both of the chip and the wire solder is unable to release outward and results in a phenomenon of minor flaming. In this way, the durability of the light emitting diode may be influenced substantially.

In order to disclose a way overcoming the preceding defects in the prior art, the inventor has filed at the Chinese Patent Office and has been assigned Application No. 00107611.6 entitled "Light Emitting Diode and Making Method with Blank Thereof. (The same invention also has been filed as a European Patent Application No. 00111453 (EP-A-1160881) and a U.S. Patent Application No. 09/582,236 respectively). EP-A-1160881 relates to prior art according to Articles 54(3) and (4) EPC.

### SUMMARY OF THE INVENTION

An object of the present invention is to provide an improved light emitting diode, with which the heat generated therein may be transmitted through exposed connecting pins to ease the heat dissipation.

### BRIEF DESCRIPTION OF THE DRAWINGS

The present invention can be more fully understood by referring to the following description and accompanying drawing, in which:
Fig. 1 is a perspective view of a conventional light emitting diode;
Fig. 2 is a fragmentary plan view of a blank of a conventional light emitting diode after being stamped;
Fig. 3 is perspective view of a bent blank of a conventional light emitting diode;
Fig. 4 is a perspective view of the bent blank shown in Fig. 3 in a process of sealing;
Fig. 5 is a plan view of a blank sheet of a light emitting diode according to the present invention;
Fig. 6 is a sectional view of the blank sheet shown in Fig. 5 after being bent;
Fig. 7 is a fragmentary perspective view of the light emitting diode of the present invention in the process of sealing;
Fig. 8 is a perspective view of the finished light emitting diode of the present invention;
Fig. 9 is a plan view of a blank sheet in a second embodiment of the present invention;
Fig. 10 is a sectional view of the blank sheet shown in Fig. 9 after being bent illustrating the bent blank disengaging with a support;
Fig. 11 is a sectional view similar to Fig. 10 illustrating the bent blank engaging with the support;
Fig. 12 is a fragmentary perspective view of the light emitting diode in the second embodiment of the present invention in the process of sealing;
Fig. 13 is a perspective view of the finished light emitting diode of the second embodiment of present invention;
Fig. 14 is a sectional view similar to Fig. 11 illustrating another support engaging with the bent blank; and
Fig. 15 is a plan view of a blank sheet similar to that shown in Fig. 9 illustrating connecting pin set for crystal chips in different colors.

### DETAILED DESCRIPTION OF THE PREFERRED EMBODIMENTS

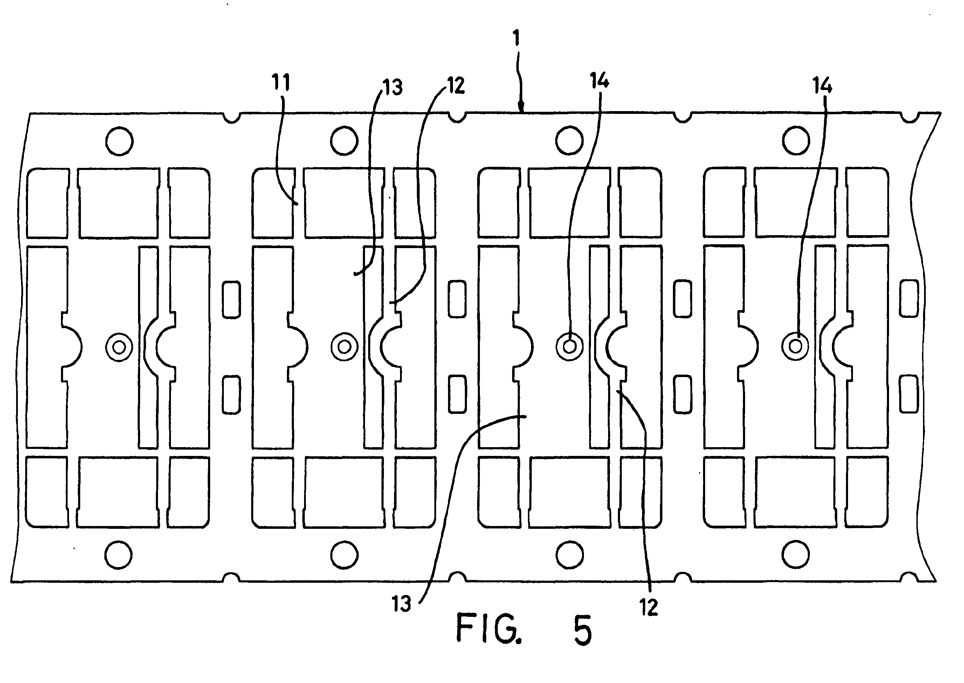

Referring to Figs. 5 to 8, the first embodiment of a light emitting diode according to the present invention basically comprises a frame 1 of a blank sheet, a crystal chip (or a crystal grain) 2, a wire solder 3, and sealing compound 4.

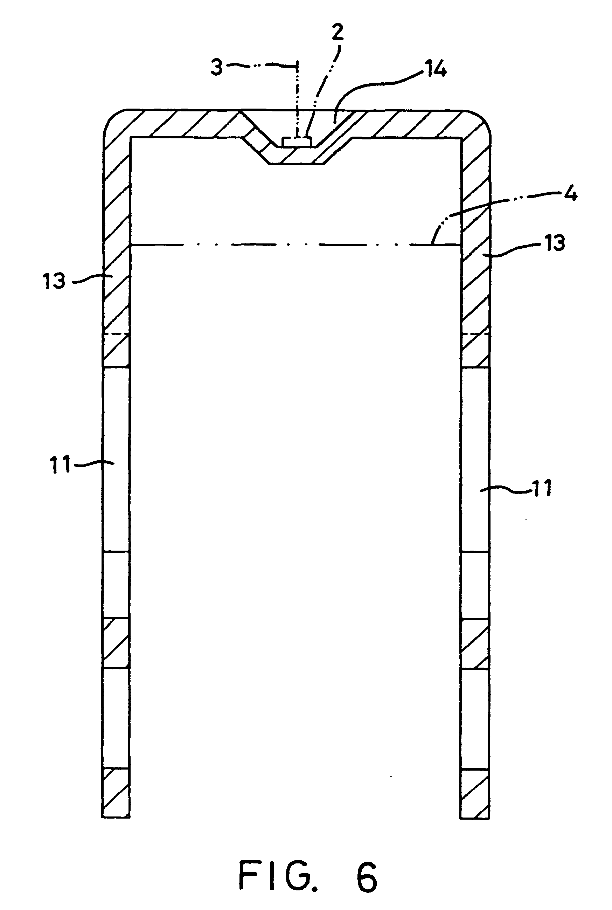

The frame 1 as shown in Fig. 5 is made of an elongated conductive sheet metal being continuously formed integrally by way of punch. Four connecting pins 11 being constituted in the process of punching are divided into two sets and one set thereof have a middle connection 12. The middle connection 12 at the central section thereof may have a circular arc but not required. Another set of connecting pins 11 is provided with a wider plate connection 13 and the middle part of the plate connection 13 is punched a recess cup 14 for placing a chip 2. As shown in Fig. 6, connecting pins 11 are vertically bent downward at margins of the middle connection 12 and the plate connection 13 respectively.

The chip 2, which is the prior art, is placed in the recess cup 14.

The wire solder 3 is made of conductive metal wire and joined to the middle connection 12 and the chip 2 by way of soldering machine to constitute a closed circuit

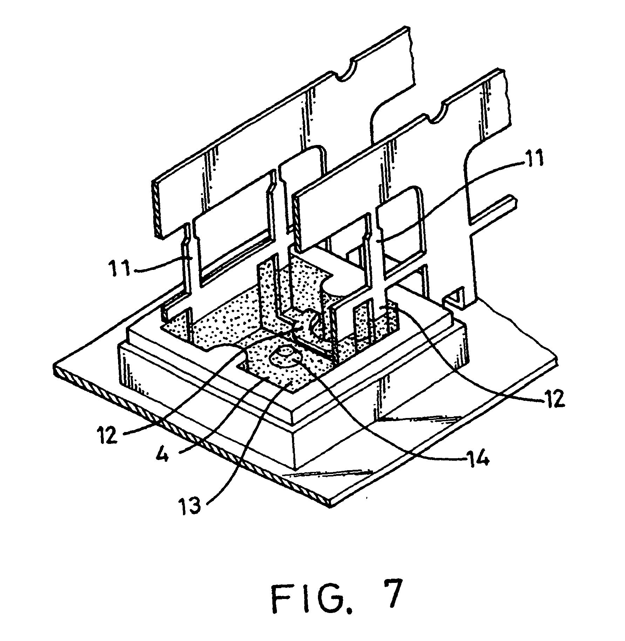

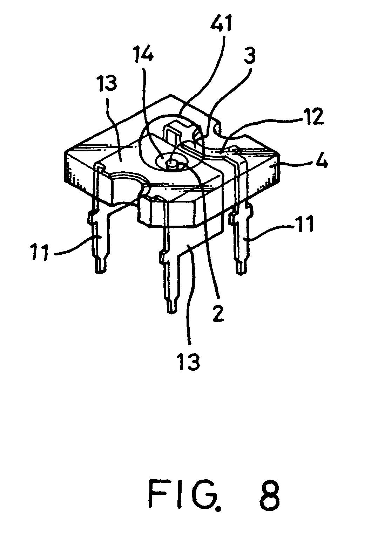

The sealing compound 4 is made of insulation material and tightly covers the chip 2, the wire solder 3, part of the plate connection and part of the middle connection 12 as shown in Fig. 7. Hence, the connecting pins are left uncovered and exposed outside. In addition, the sealing compound at the top thereof is formed a light head 41 and the light head 41 may be a shape of semi-ellipse as shown in Fig. 8. But it is not a restriction to have to be the shape of semi-ellipse.

Referring to Fig. 8 again, the finished light emitting diode of the present invention has the upper portions of the middle connection 12 and the plate connection 13 sealed and the lower portions thereof expose outside for heat dissipation. It can be understood that the transmission speed of heat is proportional to the transmitted area on which the heat may dissipate, that is, the larger transmitted area the plate connection 13 has, the faster speed of heat dissipation can be reach. Because the plate connection 13 has a width greater than that of the prior art and the lower portion thereof is exposed outside, a superior effect of heat dissipation can be obtained substantially.

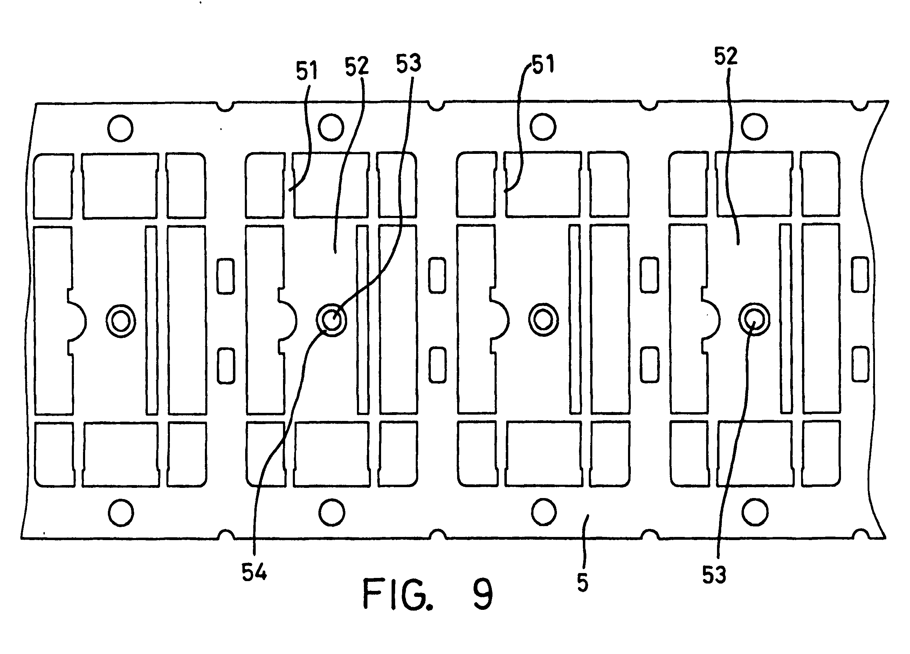

Referring to Figs. 9 to 13, a second embodiment of the present invention is illustrated. The light emitting diode in the second embodiment comprises a frame 5 composed of the blank sheet, a support 6, a crystal chip 7 (or crystal grain), a wire solder 8, and sealing compound 9.

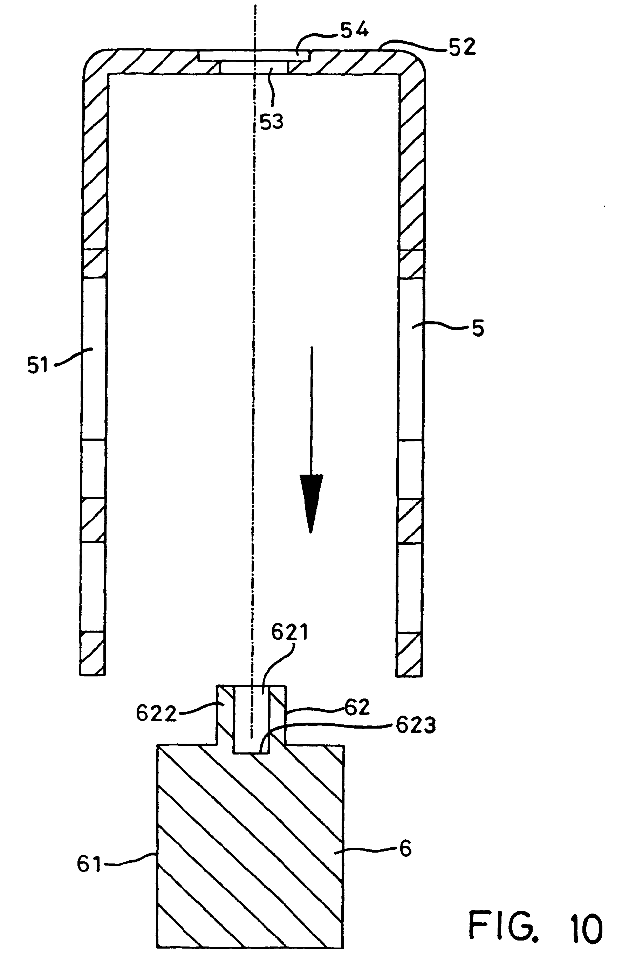

The frame 5 of the blank sheet as shown in Fig. 9 is made of elongated conductive metal being continuously punched integrally to form four connecting pins 51. These four connecting pins 51 are divided into two sets and one set of these connecting pins 51 has a wider middle plate 52. The middle plate 52 at the center thereof is provided with a fitting hole 53 and a recess ring 54 is provided to surround the fitting hole 53. As shown in Fig. 10, connecting pins 51 are bent vertically and the other set of connecting pins 51 is separate from the middle plate 52 by way of a cut.

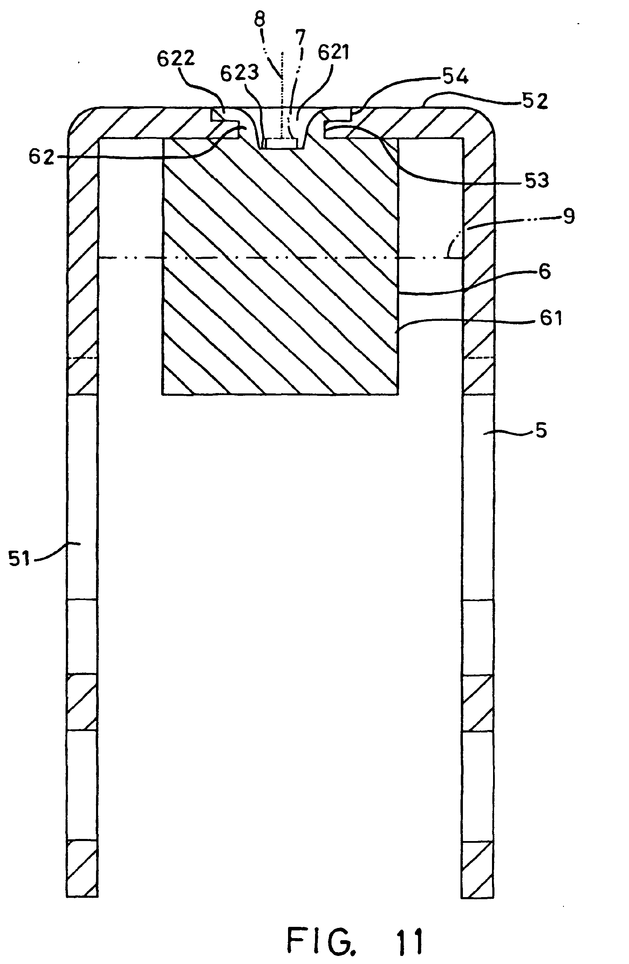

The support 6 is made of conductive metal and can be hexagon, circle, octagon, and other shapes. The support 6 is composed of a support base 61 and a support tubing 62 and the support base 61 has a bigger size and the support tubing 62 is integrally located at the top of the support base 61. The support tubing 62 has a central hole 621 and a support wall 622 and has an outer diameter corresponding to the fitting hole 53 so as to pass through the fitting hole 53. As shown in Fig. 11, the support engages with the frame 5 by way of riveting, that is, the support tubing 62 is forced to make the support wall 622 be deformed and expand outward so as to attached to the recess ring 54 tightly. The support wall 622 opens upward to constitute a shape of trumpet and the lower part of the support tubing 62 constitute a support bottom 623 for receiving the chip 7.

The chip 7 is the prior art and placed in and located at the support bottom 623.

The wire solder 8 is made of conductive metal and connects with the central part of the one set of the connecting pins 51 and the chip 7 by way of the soldering machine to constitute a closed circuit.

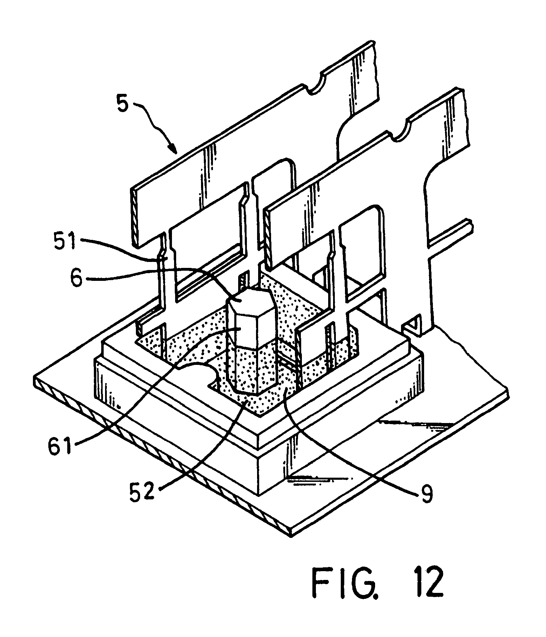

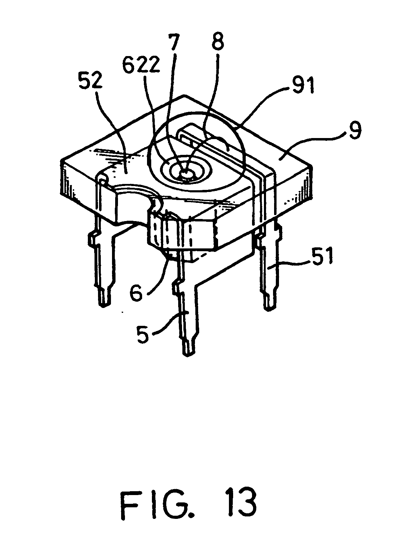

The sealing compound 9 is made of insulation material and encloses tightly the chip 7, the wire solder 8, and part of connecting pins 51 to allow connecting pins to expose outside as shown in Fig. 12. As shown in Figs. 12 and 13, the sealing compound 9 at the top thereof has a light head 91 extending outward in addition to being an enclosure. The light head 91 may be semi-ellipse but this is not a restriction. Furthermore, the support 6, part of the middle plate 52, and part of connecting pins are exposed outside.

Referring to Fig. 13, the finished light emitting diode in the second embodiment exposes the lower portion of connecting pins, part of the middle plate 52, the lower portion of support 6. The rest of the finished light emitting diode is enclosed tightly by the sealing compound 9. The bottom of support 6 and part of the middle plate expose outside for performing dissipation of heat. In addition, once the finished light emitting diode is inserted to the circuit board, the support 6 can contact with the circuit board to carry out the heat transfer for accelerating the dissipation of heat.

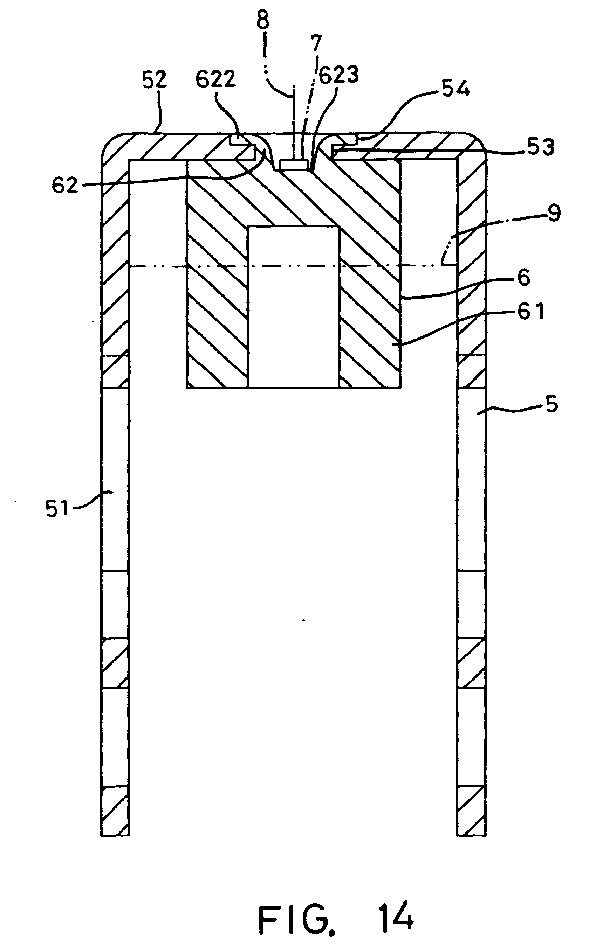

Referring to Fig. 14, another embodiment of the support 6 is illustrated. The support 6 has the support base 61 thereof provide an annular circumference with a hollow part and the annular circumference contacts with the circuit board for dissipating the heat.

Moreover, the engagement of the support 6 and the frame 5 can be by way of gluing, threaded fastening, and etc. in addition to riveting. Because these equivalent engaging ways are the prior art, no detail will be described further.

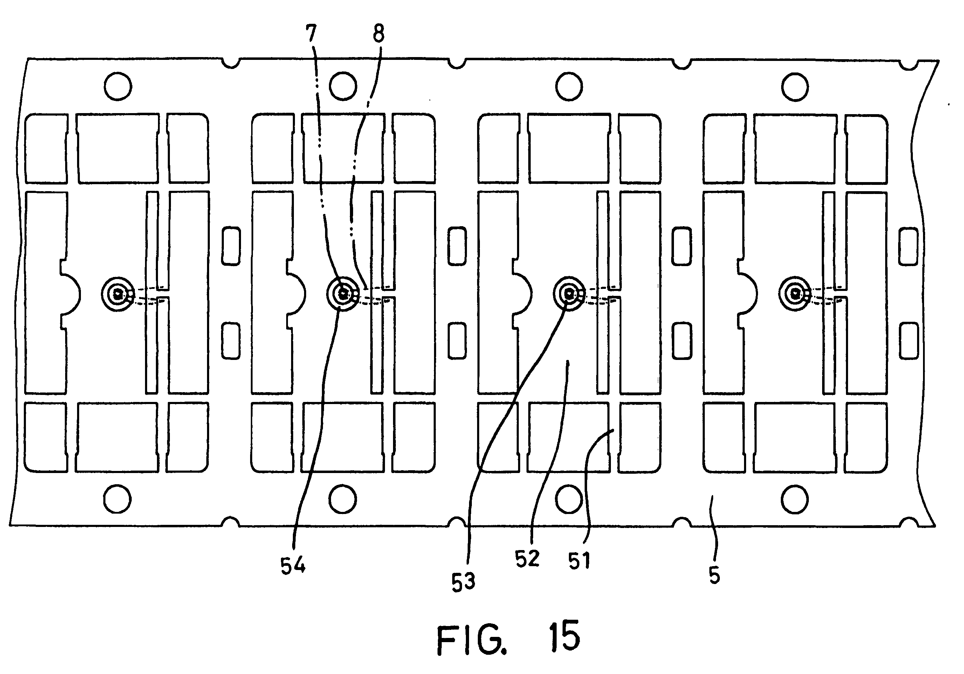

Referring to Fig. 15, the another set of connecting pins 51 next to the set of connecting pins having the chip 7 is provided with a cut at the middle thereof to connect with chips 7 in different colors. As shown in Fig. 15, while three crystal grains in three different colors such as red, green, and blue or red, yellow, and blue are arranged, the light emitting diode may display a complete combination of different colors. Because this is the prior art, no details will be explained further.

While the invention has been described with reference to preferred embodiments thereof, it is to be understood that modifications or variations may be easily made without departing from the scope of this invention, which is defined by the appended claims.

## Claims

1. A light emitting diode, comprising
a frame, being integrally made of conductive metal sheet, providing two sets of connecting pins extending vertically downwards with two connecting pins (11) for each set, a middle connection (12) joining to said two connecting pins in one of said two sets, a plate connection (13) joining to said two connecting pins in the other one of said two sets, and a recess cup (14) being formed at a middle part of the plate connection near said middle connection;
a chip (2), being placed and located in said recess cup;
a wire solder (3), being made of conductive metal wire, an end thereof being joined to the chip and the other end thereof being joined to said middle connection; and
sealing compound (4), covering the chip, the wire solder, part of the plate connection and part of the middle connection, and being formed as a light head (41) on top of the chip;
wherein the plate connection has a width greater than that of said connecting pins, a lower portion of the plate connection which is bent vertically downwards and a lower portion of the middle connection which is bent vertically downwards being exposed outside the sealing compound for a better dissipation of heat

2. The light emitting diode as defined in claim 1, wherein the middle connection has a circular arc extending toward the recess cup.

3. The light emitting diode according to claim 1, wherein said two connecting pins joined by said middle connection are separated to connect with at least two chips in the recess cup by way of at least two wire solders.

4. A light emitting diode, comprising
a frame, being integrally made of conductive metal sheet, providing two sets of connecting pins extending vertically downwards with two connecting pins (51) for each set, said two connecting pins in one of said two sets being joined by a middle plate (52) which has a width greater than that of the connecting pins, and the middle plate having a fiffing hole (53);
a support (16), having a support tubing (62) with a support bottom (623) at an upper end thereof, said support tubing having an outer diameter corresponding to the fitting hole, a support wall (622) of the support tubing having been expanded outward as a shape of trumpet after passing through the fitting hole;
a chip (7) having been placed at the support bottom after the support tubing was formed the shape of trumpet;
a wire solder (8); being made of conductive metal wire, and connecting with said chip and the other set of connecting pins respectively; and
sealing compound (9), covering part of the frame and an upper portion of the support with the chip and the wire solde, wherein a lower portion of said middle plate which is bent vertically downwards and a lower portion of said support are exposed outside said sealing compound for a better dissipation of heat.

5. The light emitting diode according to claim 4, wherein the support has a support base (61) below the support tubing.

6. The light emitting diode according to claim 4, wherein the fitting hole is surrounded by a concentric recess ring (54) for receiving and clamping the expanded support wall.

7. The light emitting diode according to claim 4, wherein the engagement between the support and the frame is by way of riveting.

8. The light emitting diode according to claim 4, wherein the support has a round cross section.

9. The light emitting diode according to claim 4, wherein the sealing compound is formed as a light head (91) on top of the chip.

10. The light emitting diode according to claim 4, wherein said two connecting pins of said other set are separated from each other to connect with at least two chips in the support bottom by way of at least two wire solders.

## Patentansprüche

1. Licht-emittierende Diode, umfassend
einen einstückig aus einem Metallblech gefertigten Rahmen zur Schaffung von zwei sich vertikal nach unten erstreckenden Sätzen von jeweils zwei Verbindungsstiften (11) für jeden Satz,
eine mittlere, die zwei Verbindungsstifte in einem von den zwei Sätzen verbindende Verbindung (12),
eine die zwei Verbindungsstifte in dem anderen der zwei Sätze verbindende Verbindungsplatte (13) und
eine an einem mittleren Teil der Verbindungsplatte in der Nähe der mittleren Verbindung ausgebildeten napfförmigen Aussparung (14);
einen in der napfförmigen Aussparung angeordneten eingesetzten Chip (2),
einen Lötdraht (3) aus einem leitenden Metalldraht, von dem ein Ende mit dem Chip und das andere Ende mit der mittleren Verbindung verbunden ist, und
einen Dichtkörper (4) zur Abdeckung des Chips, des Lötdrahts, eines Teils der Verbindungsplatte und eines Teils der mittleren Verbindung, der als Lichtkopf (Linse) 41 auf der Oberseite des Chips ausgebildet ist,
wobei die Verbindungsplatte eine größere Breite als die Verbindungsstifte aufweist, und ein unterer, vertikal nach unten gebogener Abschnitt der Verbindungsplatte und ein unterer, vertikal nach unten gebogener Abschnitt der mittleren Verbindung sich von dem Dichtkörper zur besseren Wärmeabführung nach außen erstrecken.

2. Licht-emittierende Diode nach Anspruch 1, wobei die mittlere Verbindung einen sich in Richtung der napfförmigen Aussparung erstreckenden kreisförmigen Bogen aufweist.

3. Licht-emittierende Diode nach Anspruch 1, wobei die zwei, mittels der mittleren Verbindung verbundenen Verbindungsstifte zur Verbindung mit mindestens zwei Chips in der napfförmigen Aussparung mittels mindestens zwei Lötdrähten getrennt sind.

4. Licht-emittierende Diode, umfassend
einen einstückig aus einem Metallblech gefertigten Rahmen zur Schaffung von zwei sich vertikal nach unten erstreckenden Sätzen von jeweils zwei Verbindungsstiften (5) für jeden Satz, wobei die Verbindungsstifte in einem der zwei Sätze mittels einer Mittelplatte (52) verbunden sind, deren Breite größer als die der Verbindungsstifte ist, und die eine Passöffnung (53) aufweist,
einen Träger (16) mit einem Trägerrohr (62) mit einem Trägerboden (623) an seinem oberen Ende, wobei das Trägerrohr einen der Passöffnung entsprechenden Außendurchmesser aufweist,
eine Trägerwand (622) des Trägerrohrs, die nach dem Durchgang durch die Passöffnung nach außen trompetenförmig erweitert ist,
einen auf dem Trägerboden nach der trompetenförmigen Ausbildung des Trägerrohrs angeordneten Chip (7),
einen Lötdraht (8) aus einem leitenden Metall, der mit dem Chip und dem anderen Satz der Verbindungsstifte verbunden ist, und
einen Dichtkörper (9) zur Abdeckung eines Teils des Rahmens und eines oberen Teils des Trägers mit dem Chip und dem Lötdraht, wobei sich ein unterer Teil der mittleren nach vertikal und umgebogenen Platte und ein unterer Abschnitt des Trägers zur besseren Wärmeabführung vom Dichtkörper nach außen erstrecken.

5. Licht-emittierende Diode nach Anspruch 4, wobei der Träger unter dem Trägerrohr eine Trägerbasis (61) aufweist.

6. Licht-emittierende Diode nach Anspruch 4, wobei die Passöffnung von einer konzentrischen ringförmigen Aussparung (54) zur Aufnahme und zum Einklemmen der erweiterten Trägerwand umgeben ist.

7. Licht-emittierende Diode nach Anspruch 4, wobei der Eingriff zwischen dem Träger und dem Rahmen mittels Nieten ausgebildet ist.

8. Licht-emittierende Diode nach Anspruch 4, wobei der Träger einen runden Querschnitt aufweist.

9. Licht-emittierende Diode nach Anspruch 4, wobei der Dichtkörper auf der Oberseite des Chips als Lichtkopf (Linse)(91) ausgebildet ist.

10. Licht-emittierende Diode nach Anspruch 4, wobei die zwei Verbindungsstifte des anderen Satzes voneinander zur Verbindung mit mindestens zwei Chips in dem Trägerboden mittels mindestens zwei Lötdrähten getrennt sind.

## Revendications

1. Diode électroluminescente, comprenant
une armature, intégralement constituée d'une feuille de métal conducteur, fournissant deux ensembles de broches de connexion s'étendant verticalement vers le bas, avec deux broches de connexion (11) pour chaque ensemble, une connexion intermédiaire (12) étant jointe auxdites deux broches de connexion dans l'un desdits deux ensembles, une connexion par plaque (13) étant jointe auxdites deux broches de connexion dans l'autre desdits deux ensembles, et un renfoncement (14) étant formé au niveau d'une partie intermédiaire de la connexion par plaque, près de ladite connexion intermédiaire ;
une puce (2), placée et située dans ledit renfoncement ;
un métal d'apport sous forme de fil (3), constitué d'un fil de métal conducteur, une extrémité de celui-ci étant reliée à la puce et l'autre extrémité de celui-ci étant reliée à ladite connexion intermédiaire ; et
un composé d'étanchéité (4), recouvrant la puce, le métal d'apport sous forme de fil, une partie de la connexion par plaque et une partie de la connexion intermédiaire, et étant formé comme une tête d'éclairage (41) au sommet de la puce ;
dans laquelle la connexion par plaque possède une largeur supérieure à celle desdites broches de connexion, une partie inférieure de la connexion par plaque qui est recourbée verticalement vers le bas et une partie inférieure de la connexion intermédiaire qui est recourbée verticalement vers le bas étant exposées à l'extérieur du composé d'étanchéité afin de mieux dissiper la chaleur.

2. Diode électroluminescente selon la revendication 1, dans laquelle la connexion intermédiaire possède un arc circulaire s'étendant vers le renfoncement.

3. Diode électroluminescente selon la revendication 1, dans laquelle lesdites deux broches de connexion jointes par ladite connexion intermédiaire sont séparées afin de se connecter à au moins deux puces situées dans le renfoncement, à l'aide d'au moins deux métaux d'apport sous forme de fils.

4. Diode électroluminescente, comprenant
une armature, intégralement constituée d'une feuille de métal conducteur, fournissant deux ensembles de broches de connexion s'étendant verticalement vers le bas, avec deux broches de connexion (51) pour chaque ensemble, lesdites deux broches de connexion de l'un desdits deux ensembles étant jointes par une plaque intermédiaire (52) qui possède une largeur supérieure à celle des broches de connexion, et la plaque intermédiaire possédant un trou de fixation. (53) ;
un support (16) possédant un tube de support (62) ayant un bas de support (623) au niveau d'une extrémité supérieure de celui-ci, ledit tube de support possédant un diamètre externe correspondant au trou de fixation, une paroi de support (622) du tube de support ayant été étendue vers l'extérieur en forme de trompette après être passée dans le trou de fixation ;
une puce (7) ayant été placée au niveau du bas de support après que le tube de support ait été formé comme une trompette ;
un métal d'apport sous forme de fil (8), constitué d'un fil de métal conducteur, et étant relié à ladite puce et à l'autre ensemble de broches de connexion, respectivement ; et
un composé d'étanchéité (9), recouvrant une partie de l'armature et une partie supérieure du support avec la puce et le métal d'apport sous forme de fil, dans lequel une partie inférieure de ladite plaque intermédiaire qui est recourbée verticalement vers le bas et une partie inférieure dudit support sont exposées à l'extérieur dudit composé d'étanchéité afin de mieux dissiper la chaleur.

5. Diode électroluminescente selon la revendication 4, dans laquelle le support possède une base de support (61) sous le tube de support.

6. Diode électroluminescente selon la revendication 4, dans laquelle le trou de fixation est entouré par une bague de renfoncement concentrique (54) destinée à recevoir et à fixer la paroi de support étendue.

7. Diode électroluminescente selon la revendication 4, dans laquelle l'engagement entre le support et l'armature s'effectue à l'aide d'un rivetage.

8. Diode électroluminescente selon la revendication 4, dans laquelle le support possède une section transversale arrondie.

9. Diode électroluminescente selon la revendication 4, dans laquelle le composé d'étanchéité est formé comme une tête d'éclairage (91) au sommet de la puce.

10. Diode électroluminescente selon la revendication 4, dans laquelle lesdites deux broches de connexion dudit autre ensemble sont séparées les unes des autres afin de se connecter à au moins deux puces situées dans le bas de support, à l'aide d'au moins deux métaux d'apport sous forme de fils.
